# EUROPEAN PATENT SPECIFICATION

(11) **EP 3 164 722 B1**
(45) Date of publication and mention of the grant of the patent: **26.04.2023**
(21) Application number: 15843252.6
(22) Date of filing: 18.09.2015
(51) Int. Cl.: G01R 1/067

(54) **A CONTACT PROBE FOR A TEST DEVICE**
KONTAKTSONDE FÜR PRÜFKOPF
SONDE DE CONTACT POUR UN DISPOSITIF D'ESSAI

(30) Priority: 23.09.2014 KR 20140126987
(43) Date of publication of application: 10.05.2017
(73) Proprietor: Leeno Industrial Inc., Busan 46748 (KR)
(72) Inventor: PARK, Sang Duck, Busan 46764 (KR); JUN, Jae Young, Changwon-si Chungcheongnam-do 51607 (KR)
(74) Representative: Walaski, Jan Filip
(86) International application number: PCT/KR2015/009757
(87) International publication number: WO 2016/047963

(56) References cited:
- JP-A- H0 694 749
- JP-A- 2007 316 023
- JP-A- 2007 316 023
- JP-A- 2012 093 265
- KR-A- 20000 005 260
- KR-A- 20040 105 878
- KR-A- 20070 075 699
- KR-B1- 100 876 960
- KR-B1- 101 348 205
- US-A1- 2005 280 433
- US-A1- 2011 221 464

## Description

### Technical Field

Apparatuses and methods consistent with the exemplary embodiments relate to a contact probe for a test device, and more particularly to a contact probe, in which a spring is prevented from deterioration even when a high-current test signal is applied.

### Background Art

A semiconductor chip is formed having highly-integrated fine electronic circuits, and undergoes a test on whether each electronic circuit is normal or not.

For the test of the semiconductor chip, a contact probe for testing a semiconductor has been used. Such a contact probe electrically connects terminals of the semiconductor chip and contact points (i.e. a pad) of a test circuit board for applying test signals. In general, the semiconductor chip includes an array of terminals having very fine patterns. Therefore, a very small-sized contact probe has to be integrated and supported on a probe supporter in order to contact and test the terminals having the very fine patterns.

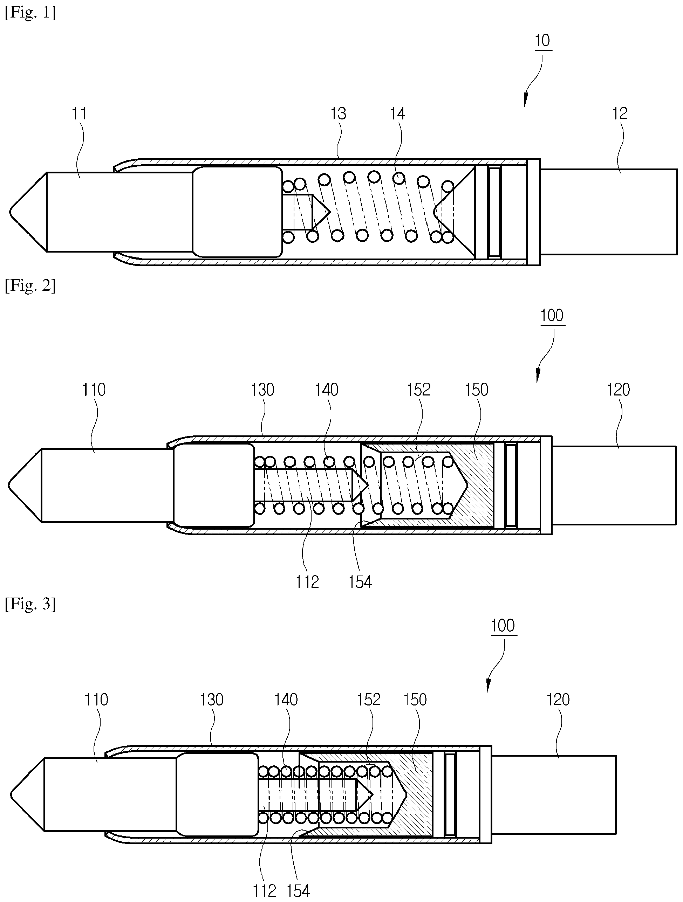

As shown in FIG. 1, a contact probe 10 includes an upper plunger 11 to contact the terminals of the semiconductor chip, a lower plunger 12 placed opposite the upper plunger 11 to contact the pad of the test circuit, a barrel 13 partially accommodating both the upper plunger 11 and the lower plunger 12, and a spring 14 interposed between the upper plunger 11 and the lower plunger 12 and providing elasticity against compression of the upper plunger 11 at the test.

The upper plunger 11 is movable to slide within the barrel 13, but the lower plunger 12 is stationary in the barrel. The spring 14 is supported on a stem provided at one end of the upper plunger 11 within the barrel 13, and is also supported on a protrusion provided at one end of the lower plunger 12. At the test, the upper plunger 11 moves compressing the spring 14. At this time, the spring 14 begins to buckle, i.e. contact an inner wall of the barrel 13 as the spring 14 becomes out of balance under increasing compression and is laterally deformed. Therefore, a test current flows through a metallic spring 14, i.e. flows the upper plunger 11, the spring 14 and the barrel 13 in sequence. Consequently, a high current for a test signal flows through a thin spring 14, and thus the spring 14 deteriorates and has a short lifespan.

US 2005/0280433 discloses an electronic test probe including a compression spring disposed in the housing in engagement with a plunger.

JP 2007316023 discloses a contact probe including a tubular conductive barrel and a conductive plunger, mounted movably in the barrel via a coil spring insulation-coated on the outer periphery.

JP2012093265 discloses a power supply connection terminal which solves the problem of reducing the inrush current per se and adversely affecting the operation of the device by the inrush current.

KR1020060004254 discloses an inspection probe device composed of a barrel, a plunger and a spring.

JPH0694749 discloses a central conductor slidably mounted on an outer conductor through a coiled spring, and flangelike insulators mounted at both ends of the spring.

### Disclosure of Invention

### Technical Problem

An aspect of an exemplary embodiment is to provide a contact probe for a high current, which can minimize buckling.

Another aspect of an exemplary embodiment is to provide a contact probe for a high current, which can minimize buckling of a spring so that the spring can have an improved lifespan.

### Solution to Problem

Still another aspect of an exemplary embodiment is to provide a contact probe for a high current, which has a simple structure to reduce production costs.

According to an aspect of the invention, there is provided a contact probe as set out in claim 1.

### Advantageous Effects of Invention

A contact probe according to exemplary embodiments is managed such that the stem of the first plunger moves within the opening of the second plunger, thereby preventing buckling of a spring.

### Brief Description of Drawings

The above and/or other aspects will become apparent and more readily appreciated from the following description of exemplary embodiments, taken in conjunction with the accompanying drawings, in which:
FIG. 1 shows a conventional contact probe;
FIG. 2 shows a contact probe according to an exemplary embodiment before a test; and
FIG. 3 shows the contact probe according to an exemplary embodiment during the test.

### Best Mode for Carrying out the Invention

Below, exemplary embodiments will be described in detail with reference to accompanying drawings. For convenience of description, parts not directly related to the present inventive concept are omitted, and like numerals refer to like elements throughout.

As shown in FIG. 2, a contact probe 100 according to an exemplary embodiment includes a first plunger 110 to be in contact with a contact point of an object to be tested, a second plunger 120 to be in contact with a contact point of a test circuit, and a barrel 130 to partially accommodate both the first plunger 110 and the second plunger 120.

The barrel 130 is shaped like a hollow cylinder capable of movably accommodating one of the first plunger 110 and the second plunger 120. The barrel 130 is made of conductive metal through which a test current can flow. Of course, only one of the first plunger 110 and the second plunger 120 may be movably accommodated in the barrel 130, and the other one may be stationarily accommodated in the barrel 130.

The barrel 130 may accommodate a spring 140 therein so that the partially accommodated first and second plungers 110 and 120 can be elastically compressed toward each other by pressure applied at a test. The spring 140 accommodated in the barrel 130 may be made of a conductive material.

As shown in FIG. 2, the first plunger 110 has one end partially accommodated in the barrel 130 and the other end protruding out of the barrel 130, and is thus movable to slide in a direction of compressing the spring 140. The first plunger 110 includes a stem 112 formed at one end accommodated in the barrel 130 and supporting one side of the spring 140. The stem 112 may be sufficiently long and extended toward the opposite second plunger 120 within the barrel 130. A free end of the stem 112 is accommodated in an opening hole 152 of the second plunger 120 to be described later.

The second plunger 120 has one end partially accommodated in the barrel 130 and the other end protruding out of the barrel 130. One end of the second plunger 120 accommodated in the barrel 130 includes the opening hole 152 to accommodate the stem 112 of the first plunger 110, and is stationary in the barrel 130. Alternatively, the second plunger 120 may be not stationary but movable in the barrel 130. One end of the second plunger 120 accommodated in the barrel 130 comprises the insulating member 150. At this time, the opening hole 152 may be formed in the insulating member 150. The opening hole 152 may be internally coated with an insulating film. Alternatively according to the present disclosure which does not form part of the invention, the opening hole 152 may be internally formed with an insulating tube.

The opening hole 152 accommodates the other side of the spring 140. The opening hole 152 may have an inlet edge 154 tapered inward. For example, if the opening hole 152 has an angled inlet edge, it may get caught in between the wires of the spring 140 and thus disturb sliding motion. Therefore, it is preferable to chamfer the inlet edge of the opening hole. To this end, according to the present disclosure which does not form part of the invention, 'R' machining may be used to make the inlet edge 154 of the opening hole 152 incline.

FIG. 3 shows the contact probe according to an exemplary embodiment during the test, in which the first plunger 110 slides to compress the spring 140 in accordance with pressure applied at the test. At this time, the spring 140 is prevented from buckling by the stem 112 of the first plunger 110 and the opening hole 152 of the insulating member 150 from the state of FIG. 2 before the compression to the compressed state of FIG. 3. Therefore, the spring 140 does not contact the inner wall of the barrel 130 during the compression, and therefore a high current for a test signal cannot flow through the spring 140.

In FIG. 2, the stem 112 of the contact probe 100 does not necessarily have to be inserted in the opening hole 152 of the insulating member 150 before the test. That is, an end of the stem 112 and an inlet of the opening hole 152 may be spaced a little apart from each other as long as there is no buckling when the compression begins. However, the end of the stem 112 has to be inserted in at least the opening hole 152 when the compression is completed as shown in FIG. 3.

In the foregoing contact probe according to an exemplary embodiment, the spring between the stem and the opening hole of the insulating member is prevented from being deformed when the spring is compressed. Thus, it is possible to prevent the spring from buckling.

Although a few exemplary embodiments have been shown and described, it will be appreciated by those skilled in the art that changes may be made in these exemplary embodiments without departing from the principles of the invention. Therefore, the foregoing has to be considered as illustrative only. The scope of the invention is defined in the appended claims.

### Industrial Applicability

A contact probe may be utilized for testing the electrical characteristics of semiconductor.

## Claims

1. A contact probe (100) for electrically connecting a contact point of an object to be tested and a contact point of a test circuit, the contact probe (100) comprising:
a first plunger (110) configured to contact the contact point of the object to be tested,
a second plunger (120) configured to contact the contact point of the test circuit,
a barrel (130) made of conductive metal and configured to support at least one of the first plunger (110) and the second plunger (120) to slide therein, and
a spring (140) configured to be interposed between the first plunger (110) and the second plunger (120) within the barrel (130), wherein
one of the first plunger (110) and the second plunger (120) comprises an opening hole (152) to accommodate one end of the spring (140), and
the other one of the first plunger (110) and the second plunger (120) includes a stem (112) arranged to be accommodated in the opening hole (152), and
wherein one of the first plunger (110) and the second plunger (120) comprises an insulating member (150), and
the opening hole (152) is formed in the insulating member (150).

2. The contact probe according to claim 1, wherein the opening hole comprises an inlet (154) tapered inward.

3. The contact probe according to claim 1 or 2, wherein the opening hole is coated with an insulating film.

4. The contact probe according to claim 1 or 2, wherein the free end of the stem is disposed within the opening hole after the spring is restored due to completion of a test.

## Patentansprüche

1. Kontaktsonde (100) zum elektrischen Verbinden eines Kontaktpunkts eines zu prüfenden Objekts und eines Kontaktpunkts einer Prüfschaltung, die Kontaktsonde (100) umfassend:
einen ersten Stößel (110), der konfiguriert ist, um den Kontaktpunkt des zu prüfenden Objekts zu berühren,
einen zweiten Stößel (120), der konfiguriert ist, um den Kontaktpunkt der Prüfschaltung zu berühren,
einen Zylinder (130), der aus leitendem Metall gefertigt ist, und konfiguriert ist, um mindestens den ersten Stößel (110) und den zweiten Stößel (120) zu tragen, um darin zu gleiten, und
eine Feder (140), die konfiguriert ist, um zwischen dem ersten Stößel (110) und dem zweiten Stößel (120) innerhalb des Zylinders (130) eingefügt zu sein, wobei
einer von dem ersten Stößel (110) und dem zweiten Stößel (120) ein Öffnungsloch (152) umfasst, um ein Ende der Feder (140) aufzunehmen, und
der andere von dem ersten Stößel (110) und dem zweiten Stößel (120) einen Schaft (112) beinhaltet, der vorgesehen ist, um in dem Öffnungsloch (152) aufgenommen zu sein, und
wobei einer von dem ersten Stößel (110) und dem zweiten Stößel (120) ein Isolierelement (150) umfasst und
das Öffnungsloch (152) in dem Isolierelement (150) gebildet ist.

2. Kontaktsonde nach Anspruch 1, wobei das Öffnungsloch einen sich nach innen verjüngenden Einlass (154) umfasst.

3. Kontaktsonde nach Anspruch 1 oder 2, wobei das Öffnungsloch mit einem Isolierfilm beschichtet ist.

4. Kontaktsonde nach Anspruch 1 oder 2, wobei das freie Ende des Schafts in dem Öffnungsloch angeordnet wird, nachdem die Feder aufgrund der Beendigung einer Prüfung wiederhergestellt wurde.

## Revendications

1. Sonde de contact (100) destiné à se connecter électriquement à un point de contact d'un objet à soumettre à un essai et à un point de contact d'un circuit d'essai, la sonde de contact (100) comprenant :
un premier piston plongeur (110) conçu pour entrer en contact avec le point de contact de l'objet à soumettre à un essai,
un second piston plongeur (120) conçu pour entrer en contact avec le point de contact du circuit d'essai, un cylindre (130) constitué de métal conducteur et
conçu pour supporter au moins l'un du premier piston plongeur (110) et
du second piston plongeur (120) pour coulisser à l'intérieur de celui-ci, et
un ressort (140) conçu pour être interposé entre le premier piston plongeur (110) et
le second piston plongeur (120) à l'intérieur du cylindre (130),
l'un du premier piston plongeur (110) et du second piston plongeur (120) comprenant un trou d'ouverture (152) pour loger une extrémité du ressort (140), et
l'autre du premier piston plongeur (110) et du second piston plongeur (120) comprenant une tige (112) agencée pour être logée dans le trou d'ouverture (152), et
l'un du premier piston plongeur (110) et du second piston plongeur (120) comprenant un élément isolant (150), et
ledit trou d'ouverture (152) étant formé dans l'élément isolant (150).

2. Sonde de contact selon la revendication 1, ledit trou d'ouverture comprenant une entrée (154) conique vers l'intérieur.

3. Sonde de contact selon la revendication 1 ou 2, ledit trou d'ouverture étant revêtu d'un film isolant.

4. Sonde de contact selon la revendication 1 ou 2, ladite extrémité libre de la tige étant disposée à l'intérieur du trou d'ouverture après le rétablissement du ressort suite à l'achèvement d'un essai.
